# EUROPEAN PATENT SPECIFICATION

(11) **EP 1 486 828 B1**
(45) Date of publication and mention of the grant of the patent: **09.10.2013**
(21) Application number: 04253354.7
(22) Date of filing: 04.06.2004
(51) Int. Cl.: G03F 7/20

(54) **Lithographic apparatus and device manufacturing method**
Lithographischer Apparat und Verfahren zur Herstellung einer Vorrichtung
Appareil lithographique et méthode de fabrication d'un dispositif

(30) Priority: 09.06.2003 EP 03253636; 29.08.2003 EP 03255395; 10.11.2003 EP 03257068
(43) Date of publication of application: 15.12.2004
(73) Proprietor: ASML Netherlands B.V., 5504 DR Veldhoven (NL)
(72) Inventor: Lof, Joeri, 5616 BW, Eindhoven (NL); Bijlaart, Erik Theodorus Maria, 5247 XM Rosmalen (NL); Butler, Hans, 5685 AC Best (NL); Donders, Sjoerd Nicolaas Lamburtus, 5211 HN's-Hertogenbosch (NL); Hoogendam, Christiaan Alexander, 5509 NC Veldhoven (NL); Kolesnychenko, Aleksey, 5701 EE Helmond (NL); Loopstra, Erik Roelof, 5591 BA Heeze (NL); Meijer, Hendricus Johannes Maria, 5506 CA Velhoven (NL); Mertens, Jeroen Johannes Sophia Maria, 5525 BC Duizel (NL); Van de Kerkhof, Marcus Adrianus, 5708 GT (NL); Mulkens, Johannes Catharinus Hubertus, 5581 AB Waalre (NL); Ritsema, Roelof Aeiko Siebrand, 5615 RK Eindhoven (NL); Van Schaik, Frank, 5658 ED Eindhoven (NL); Sengers, Timotheus Franciscus, 5236 SM's-Hertogenbosch (NL); Simon, Klaus, 5655 CP Eindhoven (NL); De Smit, Joannes Theodoor, 5642 NB Eindhoven (NL); Straaijer, Alexander, 5644 KK Eindhoven (NL); Streefkerk, Bob, 5038 PE Tiburg (NL); Van Santen, Helmar, 1018 BB Amsterdam (NL); Kroon, Mark, 3531 VB Utrecht (NL); Den Boef, Arie Jeffrey, 5581 NA Waalre (NL); Ottens, Joost Jeroen, 5508 TR Veldhoven (NL)
(74) Representative: Corcoran, Gregory Martin Mason

(56) References cited:
- EP-A- 0 834 773
- EP-A1- 1 571 701
- EP-A1- 1 628 330
- PATENT ABSTRACTS OF JAPAN vol. 1999, no. 12, 29 October 1999 (1999-10-29) & JP 11 176727 A (NIKON CORP), 2 July 1999 (1999-07-02)

## Description

The present invention relates to a lithographic projection apparatus comprising:
- an object table for holding an object;
- a projection system for projecting the patterned beam onto a target portion of a substrate; and
- a liquid supply system for at least partly filling the space between the final element of said projection system and an object positioned on said substrate table, with liquid.

The term "patterning means" as here employed should be broadly interpreted as referring to means that can be used to endow an incoming radiation beam with a patterned cross-section, corresponding to a pattern that is to be created in a target portion of the substrate; the term "light valve" can also be used in this context. Generally, the said pattern will correspond to a particular functional layer in a device being created in the target portion, such as an integrated circuit or other device (see below). Examples of such patterning means include:
- A mask. The concept of a mask is well known in lithography, and it includes mask types such as binary, alternating phase-shift, and attenuated phase-shift, as well as various hybrid mask types. Placement of such a mask in the radiation beam causes selective transmission (in the case of a transmissive mask) or reflection (in the case of a reflective mask) of the radiation impinging on the mask, according to the pattern on the mask. In the case of a mask, the support structure will generally be a mask table, which ensures that the mask can be held at a desired position in the incoming radiation beam, and that it can be moved relative to the beam if so desired.
- A programmable mirror array. One example of such a device is a matrix-addressable surface having a viscoelastic control layer and a reflective surface. The basic principle behind such an apparatus is that (for example) addressed areas of the reflective surface reflect incident light as diffracted light, whereas unaddressed areas reflect incident light as undiffracted light. Using an appropriate filter, the said undiffracted light can be filtered out of the reflected beam, leaving only the diffracted light behind; in this manner, the beam becomes patterned according to the addressing pattern of the matrix-addressable surface. An alternative embodiment of a programmable mirror array employs a matrix arrangement of tiny mirrors, each of which can be individually tilted about an axis by applying a suitable localized electric field, or by employing piezoelectric actuation means. Once again, the mirrors are matrix-addressable, such that addressed mirrors will reflect an incoming radiation beam in a different direction to unaddressed mirrors; in this manner, the reflected beam is patterned according to the addressing pattern of the matrix-addressable mirrors. The required matrix addressing can be performed using suitable electronic means. In both of the situations described hereabove, the patterning means can comprise one or more programmable mirror arrays. More information on mirror arrays as here referred to can be gleaned, for example, from United States Patents US 5,296,891 and US 5,523,193, and PCT patent applications WO 98/38597 and WO 98/33096. In the case of a programmable mirror array, the said support structure may be embodied as a frame or table, for example, which may be fixed or movable as required.
- A programmable LCD array. An example of such a construction is given in United States Patent US 5,229,872. As above, the support structure in this case may be embodied as a frame or table, for example, which may be fixed or movable as required.

For purposes of simplicity, the rest of this text may, at certain locations, specifically direct itself to examples involving a mask and mask table; however, the general principles discussed in such instances should be seen in the broader context of the patterning means as hereabove set forth.

Lithographic projection apparatus can be used, for example, in the manufacture of integrated circuits (ICs). In such a case, the patterning means may generate a circuit pattern corresponding to an individual layer of the IC, and this pattern can be imaged onto a target portion (e.g. comprising one or more dies) on a substrate (silicon wafer) that has been coated with a layer of radiation-sensitive material (resist). In general, a single wafer will contain a whole network of adjacent target portions that are successively irradiated via the projection system, one at a time. In current apparatus, employing patterning by a mask on a mask table, a distinction can be made between two different types of machine. In one type of lithographic projection apparatus, each target portion is irradiated by exposing the entire mask pattern onto the target portion in one go; such an apparatus is commonly referred to as a wafer stepper. In an alternative apparatus -commonly referred to as a step-and-scan apparatus - each target portion is irradiated by progressively scanning the mask pattern under the projection beam in a given reference direction (the "scanning" direction) while synchronously scanning the substrate table parallel or anti-parallel to this direction; since, in general, the projection system will have a magnification factor M (generally < 1), the speed V at which the substrate table is scanned will be a factor M times that at which the mask table is scanned. More information with regard to lithographic devices as here described can be gleaned, for example, from US 6,046,792.

In a manufacturing process using a lithographic projection apparatus, a pattern (e.g. in a mask) is imaged onto a substrate that is at least partially covered by a layer of radiation-sensitive material (resist). Prior to this imaging step, the substrate may undergo various procedures, such as priming, resist coating and a soft bake. After exposure, the substrate may be subjected to other procedures, such as a post-exposure bake (PEB), development, a hard bake and measurement/inspection of the imaged features. This array of procedures is used as a basis to pattern an individual layer of a device, e.g. an IC. Such a patterned layer may then undergo various processes such as etching, ion-implantation (doping), metallization, oxidation, chemo-mechanical polishing, etc., all intended to finish off an individual layer. If several layers are required, then the whole procedure, or a variant thereof, will have to be repeated for each new layer. Eventually, an array of devices will be present on the substrate (wafer). These devices are then separated from one another by a technique such as dicing or sawing, whence the individual devices can be mounted on a carrier, connected to pins, etc. Further information regarding such processes can be obtained, for example, from the book "Microchip Fabrication: A Practical Guide to Semiconductor Processing", Third Edition, by Peter van Zant, McGraw Hill Publishing Co., 1997, ISBN 0-07-067250-4.

For the sake of simplicity, the projection system may hereinafter be referred to as the "lens"; however, this term should be broadly interpreted as encompassing various types of projection system, including refractive optics, reflective optics, and catadioptric systems, for example. The radiation system may also include components operating according to any of these design types for directing, shaping or controlling the projection beam of radiation, and such components may also be referred to below, collectively or singularly, as a "lens". Further, the lithographic apparatus may be of a type having two or more substrate tables (and/or two or more mask tables). In such "multiple stage" devices the additional tables may be used in parallel, or preparatory steps may be carried out on one or more tables while one or more other tables are being used for exposures. Dual stage lithographic apparatus are described, for example, in US 5,969,441 and WO 98/40791.

It has been proposed to immerse the substrate in a lithographic projection apparatus in a liquid having a relatively high refractive index, e.g. water, so as to fill the space between the final optical element of the projection lens and the substrate. The point of this is to enable imaging of smaller features because the exposure radiation will have a shorter wavelength in the liquid than in air or in a vacuum. (The effect of the liquid may also be regarded as increasing the effective NA of the system).

However, submersing the substrate or substrate and substrate table in a bath of liquid (see for example US 4,509,852) means that there is a large body of liquid that must be accelerated during a scanning exposure. This requires additional or more powerful motors and turbulence in the liquid may lead to undesirable and unpredictable effects.

One of the solutions proposed is for a liquid supply system to provide liquid on only a localized area of the substrate and inbetween the final element of the projection system and the substrate (the substrate generally has a larger surface area than the final element of the projection system). One way which has been proposed to arrange for this is disclosed in WO 99/49504. In WO 99/49504 liquid is supplied by at least one inlet IN onto the substrate, preferably along the direction of movement of the substrate relative to the final element, and is removed by at least one outlet OUT after having passed under the projection system. That is, as the substrate is scanned beneath the element in a -X direction, liquid is supplied at the +X side of the element and taken up at the -X side. Liquid is supplied via inlet IN and is taken up on the other side of the element by outlet OUT which is connected to a low pressure source. Liquid is supplied along the direction of movement of the substrate relative to the final element, though this does not need to be the case. Various orientations and numbers of in- and out-lets positioned around the final element are possible.

EP 0,834,773A discloses a lithographic projection apparatus in accordance with the precharacterizing section of claim 1.

EP 1,628,330A and EP 1,571,701A, only citable under Article 54(3) EPC, disclose immersion lithographic apparatus.

It is an object of the present invention to provide an immersion lithographic projection apparatus with improved functionality.

This and other objects are achieved according to the invention in a lithographic apparatus as specified in the opening paragraph, characterized by at least one sensor being positioned for illumination by said projection beam of radiation which has passed through said immersion liquid and in that the liquid supply system comprises a seal member positioned below and surrounding the final element, the seal member extending above the final element of the projection system such that the liquid can rise above the final element so that a buffer of liquid is provided. In this way, no elaborate measures need to be taken to compensate the signals from the sensors to take account of the parameters measured by the sensors being measured through a different medium to that which the substrate is imaged through. However, it may be necessary to ensure that the design of the sensors is such that they are compatible for use when immersed with liquid. Sensors which can take advantage of the present invention include alignment sensors used for aligning the substrate table relative to the projection system, transmission image sensors, focus sensors, spot or dose sensors, an integrated lens interferometer and scanner and even alignment marks. In the case of an alignment sensor, the measurement gratings of the sensor can have a pitch than less than 500 nm which improves the resolution of the alignment sensor.

According to a further aspect of the present invention, there is provided a device manufacturing method comprising the steps of:
- providing a substrate that is at least partially covered by a layer of radiation-sensitive material;
- projecting a patterned projection beam of radiation onto a target portion of the layer of radiation-sensitive material,
- providing a liquid to at least partly fill the space between an object on an object table and a final element of a projection system used in said step of projecting;
characterized by projecting said beam of radiation onto a sensor through said immersion liquid and by confining said immersion liquid to the space using a seal device of a seal member, positioned below and surrounding the final element and extending above the final element of the projection system such that the liquid rises above the final element so that a buffer of liquid is provided.

Although specific reference may be made in this text to the use of the apparatus according to the invention in the manufacture of ICs, it should be explicitly understood that such an apparatus has many other possible applications. For example, it may be employed in the manufacture of integrated optical systems, guidance and detection patterns for magnetic domain memories, liquid-crystal display panels, thin-film magnetic heads, etc. The skilled artisan will appreciate that, in the context of such alternative applications, any use of the terms "reticle", "wafer" or "die" in this text should be considered as being replaced by the more general terms "mask", "substrate" and "target portion", respectively.

In the present document, the terms "radiation" and "beam" are used to encompass all types of electromagnetic radiation, including ultraviolet radiation (*e.g*. with a wavelength of 365, 248, 193, 157 or 126 nm).

Embodiments of the invention will now be described, by way of example only, with reference to the accompanying schematic drawings in which:
Figure 1 depicts a lithographic projection apparatus according to an embodiment of the invention;
Figure 2 depicts the liquid reservoir of the first embodiment of the invention;
Figure 3 illustrates a substrate table;
Figure 4 illustrates an alternative form of the substrate table of Figure 3;
Figure 5 illustrates a detail of the Figure 3 or 4 substrate table;
Figure 6a illustrates a first version of a substrate table;
Figure 6b illustrates a second version of a substrate table;
Figure 6c illustrates a third version of a substrate table;
Figure 7 illustrates in detail further aspects of the substrate table of Figure 6;
Figure 8 illustrates a substrate table;
Figure 9 illustrates a substrate table;
Figure 10 illustrates a first embodiment of the present invention;
Figure 11 illustrates a second embodiment of the present invention;
Figure 12 illustrates a third embodiment of the present invention;
Figure 13 illustrates a fourth embodiment of the present invention;
Figure 14 depicts an ILIAS sensor module according to the prior art;
Figure 15 depicts an ILIAS sensor module with an elongated transmissive plate according to an embodiment of the present invention;
Figure 16 depicts an ILIAS sensor module with a filler sheet according to an embodiment of the present invention; and
Figure 17a and 17b depict a luminescence based DUV TIS according to the prior art.

In the Figures, corresponding reference symbols indicate corresponding parts.

### Embodiment 1

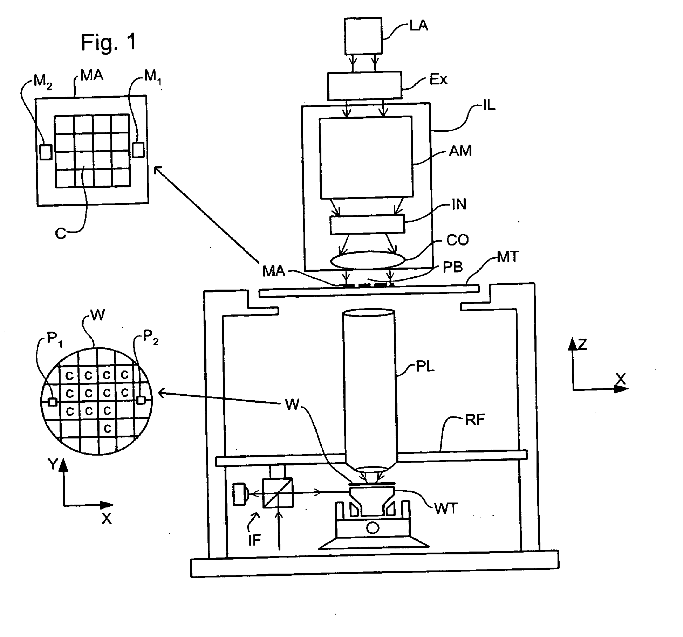

Figure 1 schematically depicts a lithographic projection apparatus according to a particular embodiment of the invention. The apparatus comprises:
- a radiation system Ex, IL, for supplying a projection beam PB of radiation (*e.g.* DUV radiation), which in this particular case also comprises a radiation source LA;
- a first object table (mask table) MT provided with a mask holder for holding a mask MA (*e.g.* a reticle), and connected to first positioning means for accurately positioning the mask with respect to item PL;
- a second object table (substrate table) WT provided with a substrate holder for holding a substrate W (*e.g.* a resist-coated silicon wafer), and connected to second positioning means for accurately positioning the substrate with respect to item PL;
- a projection system ("lens") PL (*e.g.* a refractive system) for imaging an irradiated portion of the mask MA onto a target portion C (*e.g.* comprising one or more dies) of the substrate W.
As here depicted, the apparatus is of a transmissive type (*e.g.* has a transmissive mask). However, in general, it may also be of a reflective type, for example (*e.g.* with a reflective mask). Alternatively, the apparatus may employ another kind of patterning means, such as a programmable mirror array of a type as referred to above.

The source LA (*e.g.* an excimer laser) produces a beam of radiation. This beam is fed into an illumination system (illuminator) IL, either directly or after having traversed conditioning means, such as a beam expander Ex, for example. The illuminator IL may comprise adjusting means AM for setting the outer and/or inner radial extent (commonly referred to as σ-outer and σ-inner, respectively) of the intensity distribution in the beam. In addition, it will generally comprise various other components, such as an integrator IN and a condenser CO. In this way, the beam PB impinging on the mask MA has a desired uniformity and intensity distribution in its cross-section.

It should be noted with regard to Figure 1 that the source LA may be within the housing of the lithographic projection apparatus (as is often the case when the source LA is a mercury lamp, for example), but that it may also be remote from the lithographic projection apparatus, the radiation beam which it produces being led into the apparatus (*e.g.* with the aid of suitable directing mirrors); this latter scenario is often the case when the source LA is an excimer laser. The current invention and Claims encompass both of these scenarios.

The beam PB subsequently intercepts the mask MA, which is held on a mask table MT. Having traversed the mask MA, the beam PB passes through the lens PL, which focuses the beam PB onto a target portion C of the substrate W. With the aid of the second positioning means (and interferometric measuring means IF), the substrate table WT can be moved accurately, *e.g.* so as to position different target portions C in the path of the beam PB. Similarly, the first positioning means can be used to accurately position the mask MA with respect to the path of the beam PB, *e.g.* after mechanical retrieval of the mask MA from a mask library, or during a scan. In general, movement of the object tables MT, WT will be realized with the aid of a long-stroke module (course positioning) and a short-stroke module (fine positioning), which are not explicitly depicted in Figure 1. However, in the case of a wafer stepper (as opposed to a step-and-scan apparatus) the mask table MT may just be connected to a short stroke actuator, or may be fixed.

The depicted apparatus can be used in two different modes:
1. In step mode, the mask table MT is kept essentially stationary, and an entire mask image is projected in one go (*i.e.* a single "flash") onto a target portion C. The substrate table WT is then shifted in the x and/or y directions so that a different target portion C can be irradiated by the beam PB;
2. In scan mode, essentially the same scenario applies, except that a given target portion C is not exposed in a single "flash". Instead, the mask table MT is movable in a given direction (the so-called "scan direction", *e.g.* the y direction) with a speed *v*, so that the projection beam PB is caused to scan over a mask image; concurrently, the substrate table WT is simultaneously moved in the same or opposite direction at a speed *V = Mv,* in which *M* is the magnification of the lens PL (typically, *M =* 1/4 or 1/5). In this manner, a relatively large target portion C can be exposed, without having to compromise on resolution.

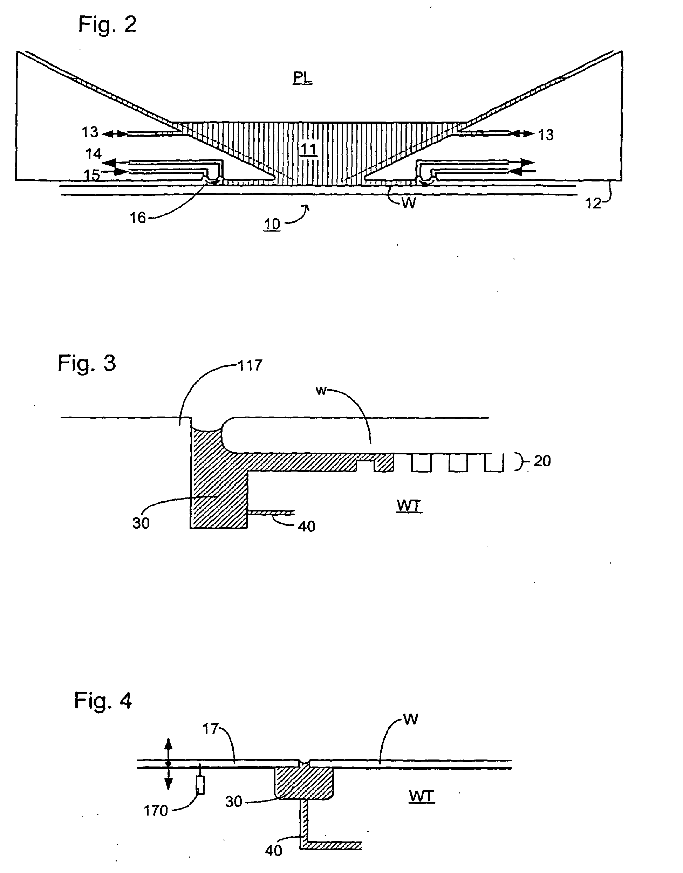

Figure 2 shows a liquid reservoir 10 between the projection system PL and the substrate W which is positioned on the substrate stage WT. The liquid reservoir 10 is filled with a liquid 11 having a relatively high refractive index, e.g. water or a suspension of particles in water, provided via inlet/outlet ducts 13. The liquid has the effect that the radiation of the projection beam is a shorter wavelength in the liquid than in air or in a vacuum, allowing smaller features to be resolved. It is well known that the resolution limit of a projection system is determined, inter alia, by the wavelength of the projection beam and the numerical aperture of the system. The presence of the liquid may also be regarded as increasing the effective numerical aperture. Furthermore, at fixed numerical aperture, the liquid is effective to increase the depth of field.

The reservoir 10 forms a preferably contactless seal to the substrate W around the image field of the projection lens PL so that the liquid is confined to fill the space between the substrate's primary surface, which faces the projection system PL, and the final optical element of the projection system PL. The reservoir is formed by a seal member 12 positioned below and surrounding the final element of the projection lens PL. Thus, the liquid supply system provides liquid on only a localised area of the substrate. The seal member 12 forms part of the liquid supply system for filling the space between the final element of the projection system and the substrate with a liquid. This liquid is brought into the space below the projection lens and within the seal member 12. The seal member 12 extends a little above the bottom element of the projection lens and the liquid rises above the final element so that a buffer of liquid is provided. The seal member 12 has an inner periphery that at the upper end closely conforms to the shape of the projection system or the final elements thereof and may, e.g. be round. At the bottom the inner periphery closely conforms to the shape of the image field, e.g. rectangular, though this is not necessarily so. The seal member is substantially stationary in the XY plane relative to the projection system though there may be some relative movement in the Z direction (in the direction of the optical axis). A seal is formed between the seal member and the surface of the substrate. This seal is preferably a contactless seal and may be a gas seal.

The liquid 11 is confined in the reservoir 10 by a seal device 16. As illustrated in Figure 2, the seal device is a contactless seal i.e. a gas seal. The gas seal is formed by gas, e.g. air or synthetic air, provided under pressure via inlet 15 to the gap between seal member 12 and substrate W and extracted by first outlet 14. The over pressure on the gas inlet 15, vacuum level or under pressure on the first outlet 14 and the geometry of the gap are arranged so that there is a high-velocity air flow inwards towards the optical axis of the apparatus that confines the liquid 11. As with any seal, some liquid is likely to escape, for example up the first outlet 14.

Thus, as used herein for the embodiments, the liquid supply system can comprise that as described in relation to Figure 2.

### Example 1

Example 1 is illustrated in Figures 3 to 5 and is the same or similar as the first embodiment except as described below.

In the example of Figures 3 and 4 an edge liquid supply system provides liquid to a reservoir 30 via a port 40. The liquid in the reservoir 30 is optionally the same as the immersion liquid in the liquid supply system. The reservoir 30 is positioned on the opposite side of the substrate W to the projection lens and adjacent the edge of the substrate W and the edge of the edge seal member 17, 117. In Figure 4, the edge seal member 17 is comprised of an element which is separate to the substrate table WT whereas in Figure 3 the edge seal member 117 is provided by an integral portion of the substrate table WT. As can be seen most clearly from Figure 3, the substrate W is supported on the substrate table WT by a so-called pimple table 20. The pimple table 20 comprises a plurality of projections on which the substrate W rests. The substrate W is held in place by, e.g., a vacuum source sucking the substrate onto the top surface of the substrate table WT. With the use of the reservoir 30, when the edge of the substrate W is being imaged, (i.e. when liquid in the liquid supply system under the projection lens traverses across an edge of the substrate), liquid cannot escape from the liquid supply system into the gap between the edge seal member 17, 117 and the substrate W because that space is already filled with liquid.

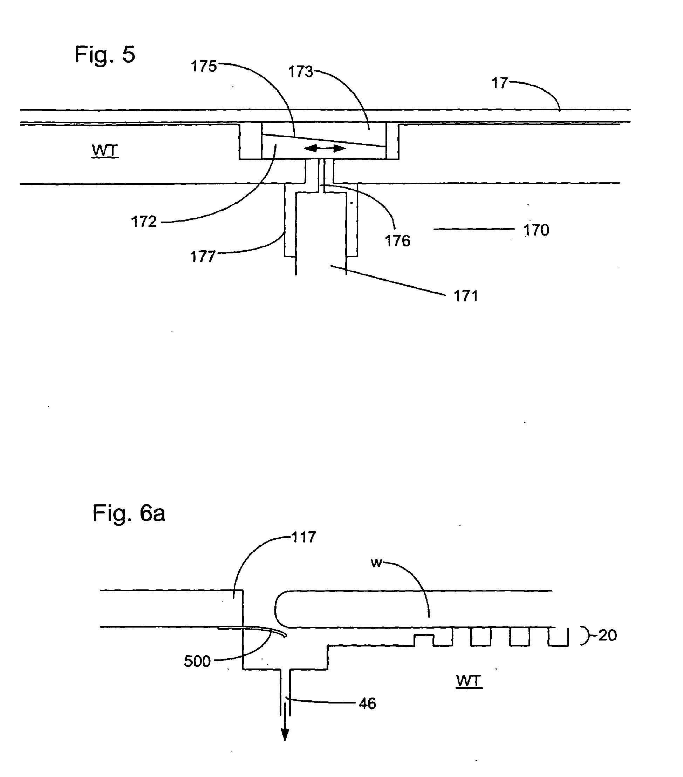

The mechanism 170 shown in Figure 4 for moving the edge seal member 17 relative to the remainder of the substrate table WT is illustrated in detail in Figure 5. The reason for moving the edge seal member 17 in this way is so that its primary surface can be made to be substantially co-planar with the primary surface of the substrate W. This allows a smooth movement of the liquid supply system over edge portions of the substrate W so that the bottom inner periphery of the liquid supply system can be moved to positions partly on the primary surface of substrate W and partly on the primary surface of the edge seal member 17.

A level sensor (not illustrated) is used to detect the relative heights of the primary surfaces of the substrate W and the edge seal member 17. Based on the results of the level sensor, control signals are sent to the actuator 171 in order to adjust the height of the primary surface of the edge seal member 17. A closed loop actuator could also be used for this purpose.

The actuator 171 is a rotating motor which rotates a shaft 176. The shaft 176 is connected to a circular disc at the end distal to the motor 171. The shaft 176 is connected away from the centre of the disc. The disc is located in a circular recess in a wedge portion 172. Ball bearings may be used to reduce the amount of friction between the circular disc and the sides of the recess in the wedge portion 172. The motor 171 is held in place by leaf springs 177. On actuation of the motor the wedge portion is driven to the left and right as illustrated (i.e. in the direction of the slope of the wedge portion) because of the excentre position of the shaft 176 in the disc. The motor is prevented from moving in the same direction as the direction of movement of the wedge portion 172 by the springs 177.

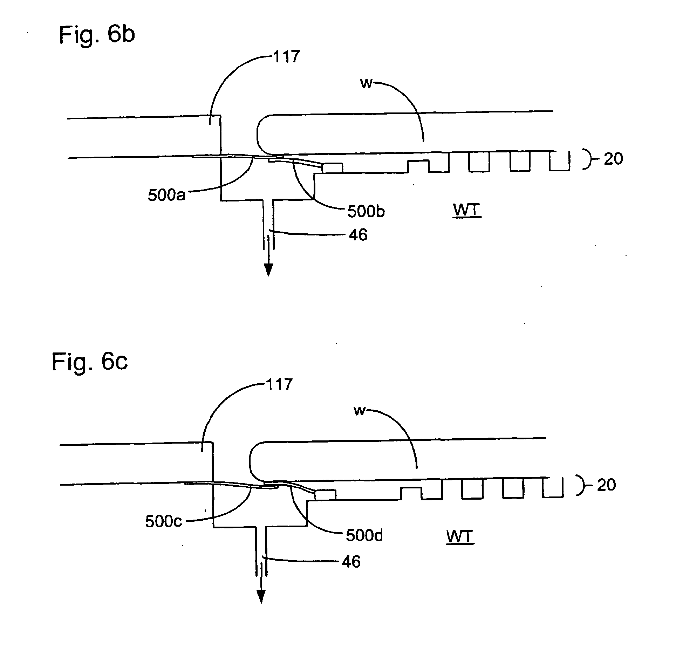

As the wedge portion 172 moves left and right as illustrated in Figure 6, its top surface 175 (which is the surface of the wedge which is sloped in relation to the primary surface of the edge seal member 17) contacts the bottom sloped surface of a further wedge member 173 which is fixed to the bottom of the edge seal member 17. The edge seal member 17 is prevented from moving in the direction of movement of the wedge member 172 so that when the wedge member 172 moves left and right the edge seal member 17 is lowered and raised respectively. Some biasing of the edge seal member 17 towards the substrate table WT may be necessary.

Obviously the further wedge member 173 could be replaced by an alternative shape, for example a rod positioned perpendicularly to the direction of movement of the wedge 172. If the coefficient of friction between the wedge member 172 and the further wedge member 173 is greater than the tangent of the wedge angle then the actuator 170 is self-braking meaning that no force is required on the wedge member 172 to hold it in place. This is advantageous as the system will then be stable when the actuator 171 is not actuated. The accuracy of the mechanism 170 is of the order of a few µm.

Especially in the case of the edge seal member 117 being an integral part of the substrate table WT, a mechanism may be provided to adjust the height of the substrate W or the member supporting the substrate W so that the primary surfaces of the edge seal member 17, 117 and the substrate can be made substantially co-planar.

### Example 2

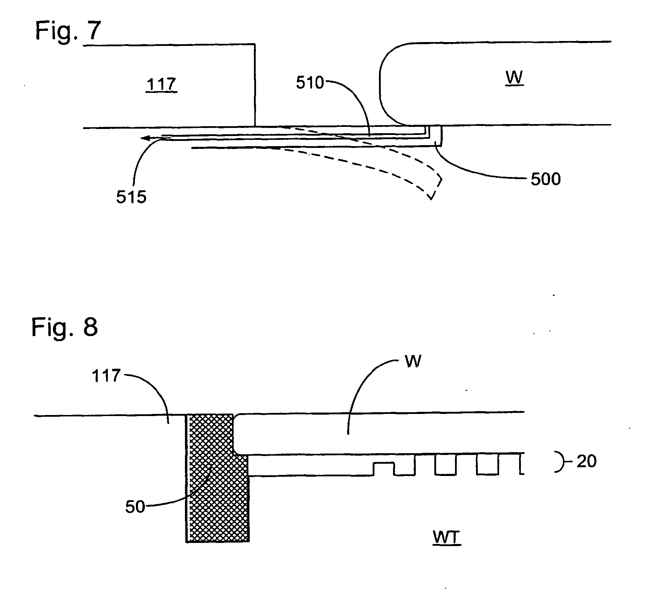

Example 2 is illustrated in Figures 6 and 7 and is the same or similar as the first embodiment except as described below.

This example is described in relation to an edge seal member 117 which is an integral part of the substrate table WT. However, this embodiment is equally applicable to an edge seal member 17 which is movable relative to the substrate table WT.

In a first version of this example as illustrated in Figure 6a, a further edge seal member 500 is used to bridge the gap between the edge seal member 117 and the substrate W. The further edge seal member is affixed to the edge seal member 117. The further edge seal member 500 is removably attachable against the surface of the substrate W opposite the primary surface. In this embodiment the further edge seal member 500 can be a flexible edge seal member which is actuatable to contact the under surface of the substrate W. When the flexible edge seal member 500 is deactivated it falls away from the substrate under gravity. The way this is achieved is illustrated in Figure 7 and is described below.

It is likely that the further edge seal member 500 will not prevent all of the immersion liquid from the liquid supply system from entering the space under the substrate W and for this reason a port 46 connected to a low pressure source may be provided under the substrate W adjacent edges of the edge seal member 117 and the substrate W in some or all of the versions of this embodiment. Of course the design of the area under the substrate could be the same as that of the third embodiment.

The same system can be used for sensors such as a transmission image sensor (TIS) on the substrate table as opposed for the substrate W. In the case of sensors, as the sensors do not move, the edge seal member 500 can be permanently attached to the sensor, for example using glue.

Furthermore, the edge seal member 500 can be arranged to engage with the top surface of the object (that surface closest to the projection system) rather than the bottom surface. Also, the further edge seal member 500 may be provided attached to or near the top surface of the edge seal member 117 as opposed to under the edge seal member 117 as is illustrated in Figure 8a.

A second version of this example is illustrated in Figure 6b. Two further edge seal members 500a, 500b are used. The first of these edge seal members 500a is the same as in the first version. The second of these edge seal members 500b is affixed to the substrate table 20 i.e. underneath the substrate W and extends with its free end radially outwardly from its attachment point. The second further edge seal member 500b clamps the first further edge seal member 500a against the substrate W. Compressed gas can be used to deform or move the second further edge seal member 500b.

A third version of this example is shown in Figure 6c. The third version is the same as the second version except the first further edge seal member 500c clamps the second further edge seal member 500d to the substrate W. This avoids, for example, the need for the compressed gas of the second version.

It will be appreciated that the embodiment will also work with only the second further edge seal member 500b, 500d with or without connection to vacuum.

Various ways of deforming the further edge seal members 500, 500a, 500b, 500c, 500d will now be described in relation to the first version of the embodiment.

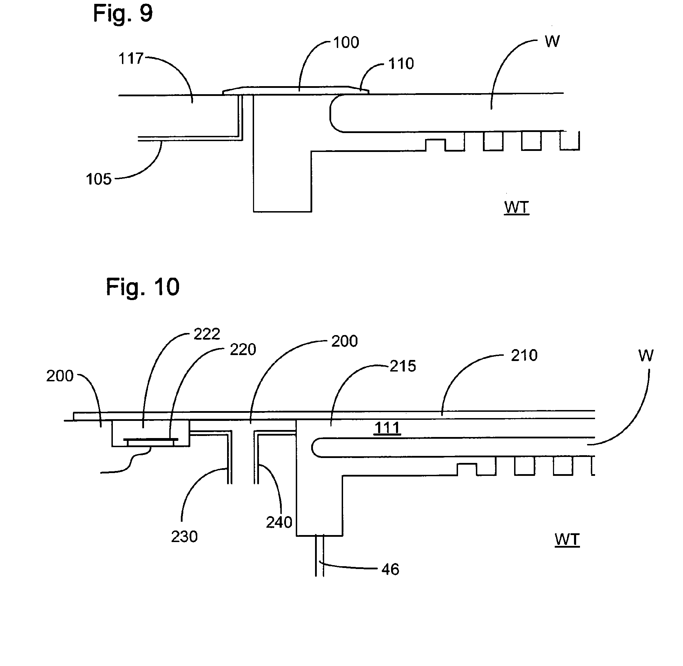

As can be seen from Figure 7, a channel 510 is formed in the elongate direction of a flexible further edge seal member 500 (which preferably is an annular ring) and (a) discreet port(s) are provided in an upper surface of the flexible further edge seal member which faces the projection system and the underside of the substrate W. By connecting a vacuum source 515 to the duct 510 the flexible further edge seal member can be made to abut the substrate W by suction. When the vacuum source 515 is disconnected or switched off, the flexible further edge seal member 500 drops under gravity and/or pressure from port 46 to assume the position shown in dotted lines in Figure 9.

In an alternative example a flexible further edge seal member 500 is formed with a mechanical pre-load such that it contacts the substrate W when the substrate is placed on the pimple table 20 and the flexible further edge seal member 500 deforms elastically so that it applies a force upwards on the substrate W to thereby make a seal.

In a further alternative, a flexible further edge seal member 500 may be forced against the substrate W by an overpressure generated by pressurised gas on port 46.

A flexible further edge seal member 500 may be fashioned from any flexible, radiation and immersion liquid resistant, non-contaminating material, for example, steel, glass e.g. Al₂O₃, ceramic material e.g. SiC, Silicon, Teflon, low expansion glasses (e.g. Zerodur (TM) or ULE (TM)), carbon fibre epoxy or quartz and is typically between 10 and 500 µm thick, preferably between 30 and 200 µm or 50 to 150 µm in the case of glass. With a flexible further edge seal member 500 of this material and these dimensions, the typical pressure which is required to be applied to the duct 510 is approximately 0.1 to 0.6 bar.

### Example 3

Example 3 is illustrated in Figure 8 and is the same or similar as the first embodiment except as described below.

This example is described in relation to an edge seal member 117 which is an integral part of the substrate table WT. However, this embodiment is equally applicable to an edge seal member 17 which is movable relative to the substrate table WT.

In the third example the gap between the edge seal member 117 and the substrate W is filled with a further edge seal member 50. The further edge seal member is a flexible further edge seal member 50 which has a top surface which is substantially co-planar with the primary surfaces of the substrate W and the edge seal member 117. The flexible further edge seal member 50 is made of a compliant material so that minor variations in the diameter of substrate W and in the thickness of the substrate W can be accommodated by deflections of the flexible further edge seal member 50. When liquid in the liquid supply system under the projection lens passes over the edge of the substrate, the liquid cannot escape between the substrate W, flexible further edge seal member 50 and edge seal member 117 because the edges of those elements are tight against one another. Furthermore, because the primary surfaces of the substrate W and the edge seal member 117 and the top surface of the flexible further edge seal member 50 are substantially co-planar, the liquid supply system operation is not upset when it passes over the edge of the substrate W so that disturbance forces are not generated in the liquid supply system.

As can be seen from Figure 8, the flexible further edge seal member 50 is in contact with a surface of the substrate W opposite the primary surface of the substrate W, at an edge portion. This contact has two functions. First the fluid seal between the flexible further edge seal member 50 and the substrate W is improved. Second, the flexible further edge seal member 50 applies a force on the substrate W in a direction away from the pimple table 20. When the substrate W is held on the substrate table WT by, e.g. vacuum suction, the substrate can be held securely on the substrate table. However, when the vacuum source is switched off or disconnected, the force produced by the flexible further edge seal member 50 on the substrate W is effective to push the substrate W off the substrate table WT thereby aiding loading and unloading of substrates W.

The flexible further edge seal member 50 is made of a radiation and immersion liquid resistant material such as PTFE.

### Example 4

Figure 9 illustrates a fourth example which is the same or similar as the first embodiment except as described below.

This example is described in relation to an edge seal member 117 which is an integral part of the substrate table WT. However, this example is equally applicable to an edge seal member 17 which is movable relative to the substrate table WT.

As can be seen from Figure 9, a further edge seal member 100 is included for bridging the gap between the edge seal member 117 and the substrate W. In this case the further edge seal member 100 is a gap seal member which is positioned on the primary surfaces of the substrate W and the edge seal member 117 to span the gap between the substrate W and edge seal member 117. Thus, if the substrate W is circular, the gap seal member 100 will also be circular (annular).

The gap seal member 100 may be held in place by the application of a vacuum 105 to its underside (that is a vacuum source exposed through a vacuum port on the primary surface of the edge seal member 117). The liquid supply system can pass over the edge of the substrate W without the loss of liquid because the gap between the substrate W and the edge seal member 117 is covered over by the gap seal means 100. The gap seal member 100 can be put in place and removed by the substrate handler so that standard substrates and substrate handling can be used. Alternatively the gap seal member 100 can be kept at the projection system PL and put in place and removed by appropriate mechanisms (e.g. a substrate handling robot). The gap seal member 100 should be stiff enough to avoid deformation by the vacuum source. Advantageously the gap seal member 100 is less than 50, preferably 30 or 20 or even 10 µm thick to avoid contact with the liquid supply system, but should be made as thin as possible

The gap seal member 100 is advantageously provided with tapered edges 110 in which the thickness of the gap seal member 100 decreases towards the edges. This gradual transition to the full thickness of the gap seal member ensures that disturbance of the liquid supply system is reduced when it passes on top of the gap seal member 100.

The same way of sealing may be used for other objects such as sensors, for example transmission image sensors. In this case, as the object is not required to move, the gap seal means 100 can be glued in place (at either end) with a glue which does not dissolve in the immersion liquid. The glue can alternatively be positioned at the junction of the edge seal member 117, the object and the gap seal means 100.

Furthermore, the gap seal means 100 can be positioned underneath the object and an overhang of the edge seal member 117. The object may be shaped with an overhang also, if necessary.

The gap seal means 100, whether above or below the object, can have a passage provided through it, from one opening in a surface in contact with the edge seal means 117 to another opening in a surface in contact with the object. By positioning one opening in fluid communication with vacuum 105, the gap seal means 100 can then be kept tightly in place.

The examples of Figures 3 to 9 do not fall within the invention in so far as they relate to sealing around the edge of a substrate as opposed to a sensor.

### Embodiment 2

The second embodiment will be described with reference to Figure 10. The solution shown in Figure 10 bypasses some of the problems associated with imaging edge portions of the substrate W as well as allows a transmission image sensor (TIS) 220 to be illuminated by the projection lens PL under the same conditions as the substrate W.

The second embodiment uses the liquid supply system described with respect to the first embodiment. However, rather than confining the immersion liquid in the liquid supply system under the projection lens on its lower side with the substrate W, the liquid is confined by an intermediary plate 210 which is positioned between the liquid supply system and the substrate W. The spaces 222, 215 between the intermediary plate 210 and the TIS 220 and the substrate W are also filled with liquid 111. This may either be done by two separate space liquid supply systems via respective ports 230, 240 as illustrated or by the same space liquid supply system via ports 230, 240. Thus the space 215 between the substrate W and the intermediary plate 210 and the space 220 between the transmission image sensor 220 and the intermediary plate 210 are both filled with liquid and both the substrate W and the transmission image sensor can be illuminated under the same conditions. Portions 200 provide a support surface or surfaces for the intermediary plate 210 which may be held in place by vacuum sources.

The intermediary plate 210 is made of such a size that it covers all of the substrate W as well as the transmission image sensor 220. Therefore, no edges need to be traversed by the liquid supply system even when the edge of the substrate W is imaged or when the transmission image sensor is positioned under the projection lens PL. The top surface of the transmission image sensor 220 and the substrate W are substantially co-planar.

The intermediate plate 210 can be removable. It can, for example, be put in place and removed by a substrate handling robot or other appropriate mechanism.

All of the above described examples may be used to seal around the edge of the substrate W. Other objects on the substrate table WT may also need to be sealed in a similar way, such as sensors including sensors and/or marks which are illuminated with the projection beam through the liquid such as the transmission image sensors, integrated lens interferometer and scanner (wavefront sensor) and spot sensor plates. Such objects may also include sensors and/or marks which are illuminated with non-projection radiation beams such as levelling and alignment sensors and/or marks. The liquid supply system may supply liquid to cover all of the object in such a case. Any of the above embodiments may be used for this purpose. In some instances, the object will not need to be removed from the substrate table WT as, in contrast to the substrate W, the sensors do not need to be removed from the substrate table WT. In such a case the above examples may be modified as appropriate (e.g. the seals may not need to be moveable).

Each of the embodiments may be combined with one or more of the other embodiments or examples as appropriate. Further, each of the embodiments (and any appropriate combination of embodiments) can be applied simply to the liquid supply system of Figure 2 and Figures 11 and 12 without the edge seal member 17, 117 as feasible and/or appropriate.

The shape of the edge seal member 117 and the top outer most edge of the sensor 220 can be varied. For example, it may be advantageous to provide an overhanging edge seal member 117 or indeed an outer edge of the sensor 220 which is overhanging. Alternatively, an outer upper corner of the sensor 220 may be useful.

### Embodiment 3

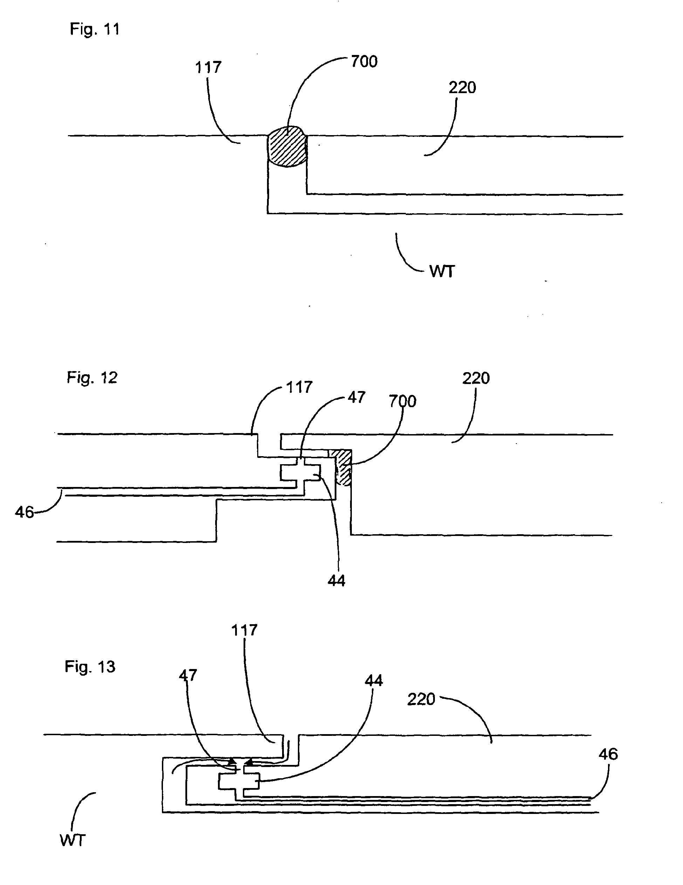

Figure 11 shows a third embodiment which is the same as the first embodiment except as described below.

In the third embodiment the object on the substrate table WT is a sensor 220 such as a transmission image sensor (TIS). In order to prevent immersion liquid seeping underneath the sensor 220, a bead of glue 700 which is undissolvable and unreactable with the immersion fluid is positioned between the edge seal member 117 and the sensor 220. The glue is covered by immersion fluid in use.

### Embodiment 4

The fourth embodiment is described with reference to Figures 12 and 13. In the fourth embodiment it is a sensor 220 which is being sealed to the substrate table WT. In both versions illustrated in Figures 12 and 13, a vacuum 46 is provided adjacent the gap with an opening passage 47 and a chamber 44 for taking away any immersion liquid which should find its way through the gap between the edge seal member 117 and the edge of the substrate 220.

In the Figure 12 version, the vacuum 46 is provided in the substrate table WT under an overhang portion of the object 220. The passage 47 is provided in an overhanging inwardly protruding portion of the substrate table WT. Optionally a bead of glue 700 is positioned at the inner most edge of the protruding portion between the substrate table WT and the object 220. If no bead of glue 700 is provided, a flow of gas from underneath the object 220 helps seal the gap between the sensor 220 and the substrate table WT.

In the version of Figure 13, the vacuum 46, compartment 44 and passage 47 are provided in the object 220 itself under an inwardly protruding edge seal member 117. Again there is the option of providing a bead of glue between the object 220 and the substrate table WT radially outwardly of the passage 47.

### Example of High NA Detection Sensor

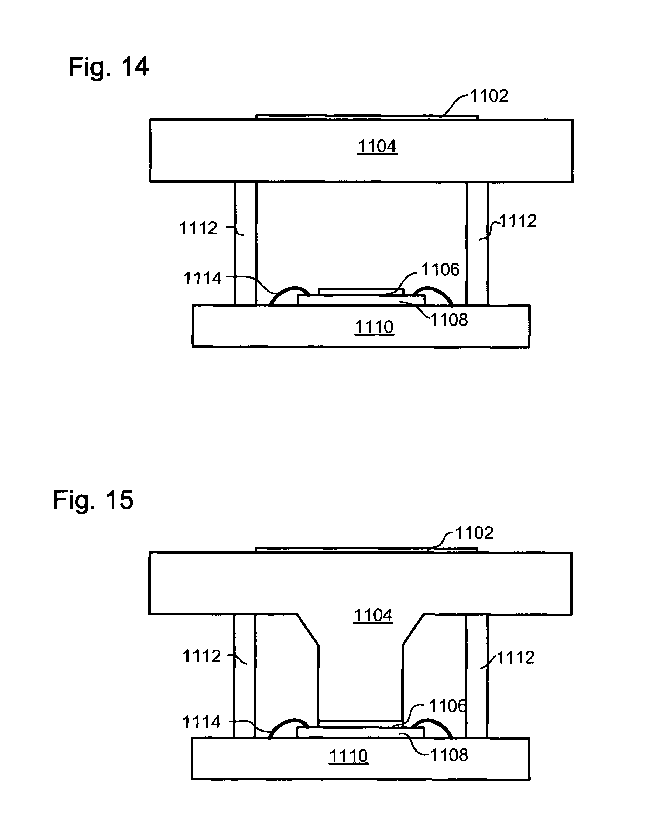

Substrate-level sensors according to embodiments of the invention comprise a radiation-receiving element (1102) and a radiation-detecting element (1108) as shown in Figure 14. Exposure radiation is directed from the final element of the projection system PL through an immersion liquid 11 at least partly filling a space between the final element of the projection system PL and the substrate W. The detailed configuration of each of these elements depends on the properties of the radiation to be detected. The sensor at substrate level may comprise a photocell only, for use in cases where it is desirable for the photocell to receive the radiation directly. Alternatively, the sensor at substrate level may comprise a luminescence layer in combination with a photocell. In this arrangement, radiation at a first wavelength is absorbed by the luminescence layer and reradiated a short time later at a second (longer) wavelength. This arrangement is useful, for example, where the photocell is designed to work more efficiently at the second wavelength.

The radiation-receiving element (1102), which may be a layer with a pinhole, a grating or another diffractive element fulfilling a similar function, may be supported on top of a quartz sensor body 1120, i.e. on the same side of the body as the projection system. The radiation-detecting element (1108), in contrast, may be arranged within the sensor body 1120, or within a concave region formed on the side of the sensor body 1120 facing away from the projection system.

At boundaries between media of different refractive indices a proportion of incident radiation will be reflected and potentially lost from the sensor. For optically smooth surfaces, the extent to which this occurs depends on the angle of incidence of the radiation and the difference in refractive index of the media in question. For radiation incident at and above a "critical angle" (conventionally measured from normal incidence) total internal reflection may occur, leading to serious loss of signal to later elements of the sensor. This may be a particular problem in high NA systems where radiation may have a higher average angle of incidence. The present invention provides arrangements whereby air is excluded from the region between the radiation-receiving (1102) and radiation-detecting (1108) elements in order to avoid interfaces between media of high refractive index and air.

In addition to losses due to partial and total internal reflection, absorption may also seriously reduce the intensity of radiation intensity reaching the photocell, as may scattering from interfaces that are not optically smooth.

Figure 14 shows an ILIAS sensor module according to the prior art. This module has a shearing grating structure 1102 as radiation-receiving element, supported by a transmissive plate 1104, which may be made of glass or quartz. A quantum conversion layer 1106 is positioned immediately above a camera chip 1108 (the radiation-detecting element), which is in turn mounted on a substrate 1110. The substrate 1110 is connected to the transmissive plate 1104 via spacers 1112 and bonding wires 1114 connect the radiation-detecting element to external instrumentation. An air gap is located between the quantum conversion layer 1106 and the transmissive plate 1104. In a setup such as this designed for 157 nm radiation, for example, the air gap within the sensor cannot easily be purged so that it will contain significant proportions of oxygen and water, which absorb radiation. Signal is therefore lost and the effect becomes worse for larger angles as these have a longer path length through air. Thus, the dynamic range requirements for the sensor become more severe.

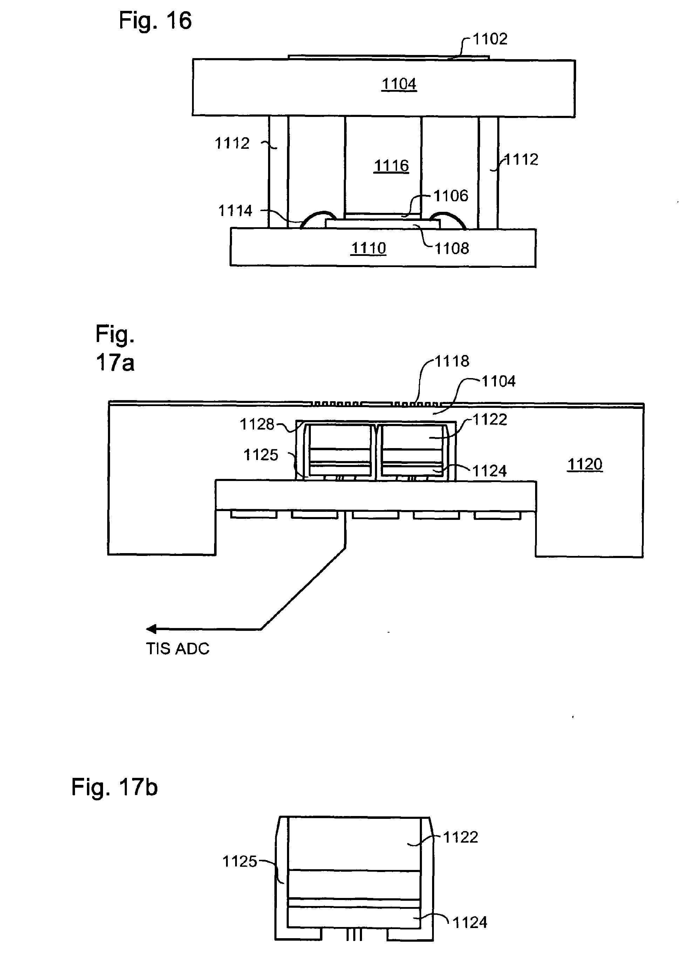

Figures 15 and 16 show improved ILIAS sensor modules according to embodiments of the present invention. In Figure 15, the air gap has been removed by changing the shape of the transmissive plate 1104 to fit directly to the camera 1108. This arrangement is made more difficult by the need to provide access for the bonding wires 1114 and necessitates an elongated form. From an engineering point of view, the alternative arrangement shown in Figure 16 is easier to realize. Here, a filler sheet 1116 of the same material as the transmissive plate 1104, or of similar optical properties, is inserted between the transmissive plate 1104 and the quantum conversion layer 1106. The removal of the air gap reduces transmission losses and relaxes dynamic range requirements (or, alternatively speaking, improves the effective dynamic range). Both arrangements improve refractive index matching and reduce the extent of spurious internal reflections at the interface with the transmissive plate 1104.

Figure 17a shows a DUV transmission image sensor according to the prior art. Figure 17b shows a magnified view of the processing element for clarity. The pattern of transmissive grooves 1118, constituting the radiation-receiving element in this case, is realized by means of e-beam lithography and dry etching techniques in a thin metal layer deposited on a substrate by means of sputtering. Any DUV light that is projected towards the grooves 1118 is transmitted by the transmissive plate 1104 (which may be quartz or fused silica) and hits the underlying luminescent material 1122, or "phosphor". The luminescent material 1122 may consist of a slab of crystalline material that is doped with rare-earth ions, e.g. yttrium-aluminium-garnet doped with cerium (YAG:Ce). The main purpose of the luminescent material 1122 is to convert the DUV radiation into more easily detectable visible radiation, which is then detected by the photodiode 1124. DUV radiation that has not been absorbed and converted into visible radiation by the phosphor 1122 may be filtered out before it reaches the photodiode 1124 (e.g. by a BG-39 or UG filter 26).

In the above arrangement, air may be present in the gaps between components mounted in the sensor housing 1125, yielding a number of air/material/air interfaces that interrupt the propagation of radiation. By considering the path of DUV radiation and radiation arising from luminescence, it is possible to identify regions where radiation is likely to be lost. The first region of interest is the rear-side 1128 of the transmissive plate 1104, reached by DUV radiation after it has passed through the grooves 1118 and transmissive plate 1104. Here, the surface has been formed by mechanical means, such as by drilling, and is inevitably rough on the scale of the wavelength of the radiation. Radiation may therefore be lost due to scattering, either back into the transmissive plate 1104 or out past the luminescent material 1122. Secondly, after this interface, the DUV light encounters the optically smooth air/YAG:Ce interface, where a substantial amount of reflection may occur due to the refractive index mismatch, particularly in systems of high NA. Thirdly, the luminescent material 1122 emits radiation in random directions. Due to its relatively high refractive index, the critical angle for total internal reflection at the YAG:Ce/air boundary is around 33° (there is air in the gap between the YAG:Ce and the filter) from the normal, meaning that a large proportion of radiation incident on the boundary is reflected out of the system and lost through the side walls of the luminescent material 1122. Finally, the part of the luminescence that is directed towards the photodiode has to overcome the air/quartz interface on the diode surface where surface roughness may again account for loss of detected signal.

Whilst specific embodiments of the invention have been described above, it will be appreciated that the invention may be practiced otherwise than as described. In particular, the invention is also applicable to other types of liquid supply systems, especially localised liquid area systems. If the seal member solution is used, it may be one in which a seal other than a gas seal is used. The description is not intended to limit the invention.

## Claims

1. A lithographic projection apparatus comprising:
- an object table (WT) for holding an object ;
- a projection system (PL) for projecting a patterned projection beam of radiation onto a target portion of a substrate (W) held on the object table (WT); and
- a liquid supply system for at least partly filling the space between the final element of said projection system (PL) and the object positioned on the object table (WT), with liquid,
**characterized by** at least one sensor (220) being positioned for illumination by said projection beam of radiation which has passed through said immersion liquid and in that the liquid supply system comprises a seal member (12) positioned below and surrounding the final element, the seal member (12) extending above the final element of the projection system such that the liquid can rise above the final element so that a buffer of liquid is provided.

2. A lithographic projection apparatus according to claim 1, wherein said sensor (220) is positioned on said object table (WT).

3. A lithographic projection apparatus according to claim 2, further comprising a gap seal member (100) positioned on a primary surface of the sensor (220) and a primacy surface of the object table (WT) to span a gap between the sensor (220) and the object table (WT).

4. A lithographic projection apparatus according to claim 3, wherein the gap seal member (100) is held in place by the application of a vacuum (105) to its underside.

5. A lithographic projection apparatus according to claim 2, wherein a bead of glue (700) which is undissoluable and unreactable with the immersion liquid is positioned between the object table (WT) and the sensor (220).

6. A lithographic projection apparatus according to claim 2 or 5, wherein the object table comprises a vacuum port (47) configured to remove liquid from a gap between the sensor (220) and the object table (WT).

7. A lithographic projection apparatus according to claim 1 or 2, wherein said object table (WT) comprises a support surface for supporting an intermediary plate (210) between said projection system (PL) and the sensor (220) and not in contact with the sensor (220).

8. An apparatus according to claim 7, wherein said object table (WT) further comprises a transmission image sensor for sensing said beam and wherein said intermediary plate (210) is positionable between said sensor (220) and said projection system (PL).

9. A lithographic projection apparatus according to any of claims 1 to 7, wherein said sensor (220) is an alignment sensor used for aligning said object table (WT) relative to said projection system (PL).

10. A lithographic projection apparatus according to claim 9, wherein measurement gratings of said alignment sensor have a pitch of less than 500 nm.

11. A lithographic projection apparatus according to any one of claims 1 to 7, wherein said sensor (220) is a transmission image sensor.

12. A lithographic projection apparatus according to any one of claims 1 to 7, wherein said sensor (220) is a focus sensor.

13. A lithographic projection apparatus according to any one of claims 1 to 7, wherein said sensor (220) is a spot or dose sensor, or an integrated lens interferometer and scanner, or alignment marks.

14. A lithographic projection apparatus according to any one of the preceding claims, wherein said substrate table (WT) further comprises an edge seal member (117) for at least partly surrounding an edge of the sensor (220) and for providing a primary surface facing said projection system (PL) substantially co-planar with a primary surface of said sensor (220) and in that said liquid supply system provides liquid to a localised area of said sensor (220).

15. A device manufacturing method comprising the steps of:
- providing a substrate (W) that is at least partially covered by a layer of radiation-sensitive material;
- projecting a patterned projection beam of radiation onto a target portion of the layer of radiation-sensitive material,
- providing a liquid to at least partly fill the space between an object on an object table (WT) and a final element of a projection system (PL) used in said step of projecting;
**characterized by** projecting said beam of radiation onto a sensor (220) through said immersion liquid and by confining said immersion liquid to the space using a seal member (12), positioned below and surrounding the final element and extending above the final element of the projection system (PL) such that the liquid rises above the final element so that a buffer of liquid is provided.

## Patentansprüche

1. Ein lithographisches Projektionsgerät, das Folgendes beinhaltet:
- einen Objekttisch (WT) zum Halten eines Objekts;
- ein Projektionssystem (PL) zum Projizieren eines gemusterten Projektionsstrahls aus Strahlung auf einen Zielabschnitt eines Substrats (W), das auf dem Objekttisch (WT) gehalten wird; und
- ein Flüssigkeitszufuhrsystem, um den Raum zwischen der Endkomponente des Projektionssystems (PL) und dem auf dem Objekttisch (WT) positionierten Objekt mindestens teilweise mit Flüssigkeit zu füllen;
**dadurch gekennzeichnet, dass** mindestens ein Sensor (220) zur Beleuchtung durch den Projektionsstrahl aus Strahlung, der durch die Immersionsflüssigkeit gegangen ist, positioniert ist, und dass das Flüssigkeitszufuhrsystem ein Dichtungselement (12) beinhaltet, das unter der Endkomponente und sie umgebend positioniert ist, wobei sich das Dichtungselement (12) über die Endkomponente des Projektionssystems erstreckt, so dass die Flüssigkeit über die Endkomponente steigen kann, so dass ein Puffer an Flüssigkeit bereitgestellt wird.

2. Lithographisches Projektionsgerät gemäß Anspruch 1, wobei der Sensor (220) auf dem Objekttisch (WT) positioniert ist.

3. Lithographisches Projektionsgerät gemäß Anspruch 2, das ferner ein Lückendichtungselement (100) beinhaltet, welches auf einer primären Oberfläche des Sensors (220) und einer primären Oberfläche des Objekttisches (WT) positioniert ist, um eine Lücke zwischen dem Sensor (220) und dem Objekttisch (WT) zu überbrücken.

4. Lithographisches Projektionsgerät gemäß Anspruch 3, wobei das Lückendichtungselement (100) durch die Anwendung eines Vakuums (105) auf seine Unterseite am Platz gehalten wird.

5. Lithographisches Projektionsgerät gemäß Anspruch 2, wobei ein Tropfen Klebstoff (700), der in der Immersionsflüssigkeit nicht löslich ist und nicht mit ihr reagiert, zwischen dem Objekttisch (WT) und dem Sensor (220) positioniert ist.

6. Lithographisches Projektionsgerät gemäß Anspruch 2 oder 5, wobei der Objekttisch eine Vakuumöffnung (47) beinhaltet, die konfiguriert ist, um Flüssigkeit von einer Lücke zwischen dem Sensor (220) und dem Objekttisch (WT) zu entfernen.

7. Lithographisches Projektionsgerät gemäß Anspruch 1 oder 2, wobei der Objekttisch (WT) eine Stützoberfläche beinhaltet, um eine zwischen dem Projektionssystem (PL) und dem Sensor (220) und nicht mit dem Sensor (220) im Kontakt befindliche Zwischenplatte (210) zu stützen.

8. Gerät gemäß Anspruch 7, wobei der Objekttisch (WT) ferner einen Durchstrahlungsbildsensor zum Wahrnehmen des Strahls beinhaltet und wobei die Zwischenplatte (210) zwischen dem Sensor (220) und dem Projektionssystem (PL) positionierbar ist.

9. Lithographisches Projektionsgerät gemäß einem der Ansprüche 1 bis 7, wobei der Sensor (220) ein Justierungssensor ist, der verwendet wird, um den Objekttisch (WT) relativ zum Projektionssystem (PL) zu justieren.

10. Lithographisches Projektionsgerät gemäß Anspruch 9, wobei Messungsgitter des Justierungssensors einen Abstand von weniger als 500 nm aufweisen.

11. Lithographisches Projektionsgerät gemäß einem der Ansprüche 1 bis 7, wobei der Sensor (220) ein Durchstrahlungsbildsensor ist.

12. Lithographisches Projektionsgerät gemäß einem der Ansprüche 1 bis 7, wobei der Sensor (220) ein Fokussensor ist.

13. Lithographisches Projektionsgerät gemäß einem der Ansprüche 1 bis 7, wobei der Sensor (220) ein Punkt- oder Dosissensor oder ein integrierter Linseninterferometer und Scanner oder Justierungsmarken ist.

14. Lithographisches Projektionsgerät gemäß einem der vorhergehenden Ansprüche, wobei der Substrattisch (WT) ferner ein Kantendichtungselement (117) beinhaltet, um eine Kante des Sensors (220) mindestens teilweise zu umgeben und um eine primäre Oberfläche bereitzustellen, die dem Projektionssystem (PL) zugewandt ist und mit einer primären Oberfläche des Sensors (220) im Wesentlichen koplanar ist, und wobei das Flüssigkeitszufuhrsystem einem örtlich begrenzten Bereich des Sensors (220) Flüssigkeit bereitstellt.

15. Ein Verfahren zum Herstellen einer Vorrichtung, das die folgenden Schritte beinhaltet:
- Bereitstellen eines Substrats (W), das mindestens teilweise mit einer Schicht aus strahlungsempfindlichem Material überzogen ist;
- Projizieren eines gemusterten Projektionsstrahls aus Strahlung auf einen Zielabschnitt der Schicht aus strahlungsempfindlichem Material;
- Bereitstellen einer Flüssigkeit, um den Raum zwischen einem Objekt auf einem Objekttisch (WT) und einer in dem Schritt des Projizierens verwendeten Endkomponente eines Projektionssystems (PL) mindestens teilweise zu füllen;
**gekennzeichnet durch** das Projizieren des Strahls aus Strahlung auf einen Sensor (220) durch die Immersionsflüssigkeit und **durch** das Begrenzen der Immersionsflüssigkeit auf den Raum unter Verwendung eines Dichtungselements (12), das unter der Endkomponente und sie umgebend positioniert ist und sich über die Endkomponente des Projektionssystems (PL) erstreckt, so dass die Flüssigkeit über die Endkomponente steigt, so dass ein Puffer an Flüssigkeit bereitgestellt wird.

## Revendications

1. Un appareil de projection lithographique comprenant :
- une table porte-objet (WT) pour porter un objet ;
- un système de projection (PL) pour projeter un faisceau de projection de rayonnement à motif sur une portion cible d'un substrat (W) porté sur la table porte-objet (WT) ; et
- un système d'alimentation en liquide pour remplir au moins partiellement l'espace entre l'organe final dudit système de projection (PL) et l'objet positionné sur la table porte-objet (WT), avec du liquide,
**caractérisé par le fait qu'**au moins un capteur (220) est positionné pour être illuminé par ledit faisceau de projection de rayonnement qui est passé à travers ledit liquide d'immersion et en ce que le système d'alimentation en liquide comprend un élément d'étanchéité (12) positionné sous et de manière à entourer l'organe final, l'élément d'étanchéité (12) s'étendant au-dessus de l'organe final du système de projection de telle sorte que le liquide puisse monter au-dessus de l'organe final afin de fournir un tampon de liquide.

2. Un appareil de projection lithographique selon la revendication 1, dans lequel ledit capteur (220) est positionné sur ladite table porte-objet (WT).

3. Un appareil de projection lithographique selon la revendication 2, comprenant en outre un élément d'étanchéité d'intervalle (100) positionné sur une surface primaire du capteur (220) et une surface primaire de la table porte-objet (WT) afin d'enjamber un intervalle entre le capteur (220) et la table porte-objet (WT).

4. Un appareil de projection lithographique selon la revendication 3, dans lequel l'élément d'étanchéité d'intervalle (100) est maintenu en place grâce à l'application d'un vide (105) sur sa surface inférieure.

5. Un appareil de projection lithographique selon la revendication 2, dans lequel une goutte de colle (700), laquelle est indissoluble et non réactive avec le liquide d'immersion, est positionnée entre la table porte-objet (WT) et le capteur (220).

6. Un appareil de projection lithographique selon la revendication 2 ou la revendication 5, dans lequel la table porte-objet comprend un orifice d'aspiration (47) configuré pour retirer du liquide d'un intervalle entre le capteur (220) et la table porte-objet (WT).

7. Un appareil de projection lithographique selon la revendication 1 ou la revendication 2, dans lequel ladite table porte-objet (WT) comprend une surface formant support pour supporter une plaque intermédiaire (210) entre ledit système de projection (PL) et le capteur (220) et non en contact avec le capteur (220).

8. Un appareil selon la revendication 7, dans lequel ladite table porte-objet (WT) comprend en outre un capteur d'image de transmission pour capter ledit faisceau et dans lequel ladite plaque intermédiaire (210) est positionnable entre ledit capteur (220) et ledit système de projection (PL).

9. Un appareil de projection lithographique selon n'importe lesquelles des revendications 1 à 7, dans lequel ledit capteur (220) est un capteur d'alignement utilisé pour aligner ladite table porte-objet (WT) relativement audit système de projection (PL).

10. Un appareil de projection lithographique selon la revendication 9, dans lequel des réseaux de mesure dudit capteur d'alignement ont un pas inférieur à 500 nm.

11. Un appareil de projection lithographique selon l'une quelconque des revendications 1 à 7, dans lequel ledit capteur (220) est un capteur d'image de transmission.

12. Un appareil de projection lithographique selon l'une quelconque des revendications 1 à 7, dans lequel ledit capteur (220) est un capteur de focalisation.

13. Un appareil de projection lithographique selon l'une quelconque des revendications 1 à 7, dans lequel ledit capteur (220) est un capteur de point ou de dose, ou un interféromètre et dispositif à balayage à lentille intégrée, ou des repères d'alignement.

14. Un appareil de projection lithographique selon l'une quelconque des revendications précédentes, dans lequel ladite table porte-substrat (WT) comprend en outre un élément d'étanchéité de bord (117) pour entourer au moins partiellement un bord du capteur (220) et pour fournir une surface primaire faisant face audit système de projection (PL) substantiellement co-planaire avec une surface primaire dudit capteur (220) et dans lequel ledit système d'alimentation en liquide fournit du liquide à une zone localisée dudit capteur (220).

15. Un procédé de fabrication de dispositif comprenant les étapes consistant à :
- fournir un substrat (W) qui est au moins partiellement recouvert d'une couche de matériau sensible au rayonnement ;
- projeter un faisceau de projection de rayonnement à motif sur une portion cible de la couche de matériau sensible au rayonnement,
- fournir un liquide afin de remplir au moins partiellement l'espace entre un objet sur une table porte-objet (WT) et un organe final d'un système de projection (PL) utilisé lors de ladite étape de projection ;
**caractérisé par** le fait de projeter ledit faisceau de rayonnement sur un capteur (220) à travers ledit liquide d'immersion et par le fait de confiner ledit liquide d'immersion à l'espace en utilisant un élément d'étanchéité (12), positionné sous et de manière à entourer l'organe final et s'étendant au-dessus de l'organe final du système de projection (PL) de telle sorte que le liquide monte au-dessus de l'organe final afin de fournir un tampon de liquide.
